# EUROPEAN PATENT SPECIFICATION

(11) **EP 3 416 926 B1**
(45) Date of publication and mention of the grant of the patent: **25.03.2026**
(21) Application number: 17715510.8
(22) Date of filing: 07.02.2017
(51) Int. Cl.: C04B 35/01, C04B 35/117, C04B 35/626, C04B 35/645, C08L 27/18, C08K 3/04

(54) **METHOD FOR ADDING A GRAPHENE-BASED ADDITIVE TO TARGET MATERIAL USED IN THE COATING APPLYING LASER ABLATION**
VERFAHREN ZUM HINZUFÜGEN EINES GRAPHENBASIERTEN ADDITIVS ZU EINEM ZIELMATERIAL ZUR VERWENDUNG IN EINER BESCHICHTUNG MIT LASERABLATION
PROCÉDÉ POUR AJOUTER UN ADDITIF À BASE DE GRAPHÈNE À UN MATÉRIAU CIBLE UTILISÉ DANS L'ABLATION AU LASER À APPLICATION DE REVÊTEMENT

(30) Priority: 18.02.2016 FI 20165127
(43) Date of publication of application: 26.12.2018
(73) Proprietor: Pulsedeon Oy, 33240 Tampere (FI)
(72) Inventor: FRANKBERG, Erkka, 33870 Tampere (FI); LEVÄNEN, Erkki, 36200 Kangasala (FI); KAISTO, Juho, 90540 Oulu (FI); CHAUDHURI, Saumyadip, 90520 Oulu (FI); KEKKONEN, Ville, 33720 Tampere (FI); LIIMATAINEN, Jari, 33240 Tampere (FI)
(74) Representative: Berggren Oy
(86) International application number: PCT/FI2017/050069
(87) International publication number: WO 2017/140943

(56) References cited:
- CN-A- 103 044 014
- CN-A- 103 897 304
- CN-B- 102 646 518
- KR-A- 20150 075 503

## Description

### Field of the invention

The invention relates to the manufacture of target materials used in a coating based on laser ablation, and especially to graphene oxide or reduced graphene oxide or pure graphene or chemically modified graphene used as one raw material in a target and to the blending methods of these materials for blending them with the powdery original raw materials before compacting it into a target.

### Background of the invention

In laser ablation, short laser pulses are targeted to the target material, making the material to detach from the target material in many different ways and to transfer the detached material towards the substrate material, forming a very well adhering and, when desired, also a very thin coating onto the surface of the base. From the point of view of the production efficiency of the coating process, it would be preferable to be able to add the quantity of material detaching from the target in a time unit, while maintaining the quality of the produced coating sufficiently good. Production efficiency can naturally be increased by increasing the capacity of lasers used, the number of lasers, pulse energy, and naturally by adjusting laser parameters to an optimal area for the process. These improvement methods have natural limitations, based on physics and also the geometry of the arrangement. Further, if it is attempted to increase productivity only by increasing the power or number of laser sources, the investment costs of production apparatuses will grow considerably. KR 2015 0075503 A discloses a method for producing a ceramic-graphene oxide composite. CN 103 044 014 A discloses a method for producing an alumina-graphene composite. CN 103 897 304 A discloses a method for producing an polytetrafluoroethylene [PTFE]-graphene oxide composite. CN 102 646 518 B discloses a method for preparing a graphene electrode material by pulsed laser deposition.

### Summary of the invention

In the present invention there is presented a method as defined in the appended claims 1-12 for boosting the coating process carried out by laser ablation by blending with the target material a controlled amount and distribution of additives intensifying and facilitating the detachment of the target material. The quantity of the blend has to be very small so that the material transferring all the way into a coating does not contain detrimental quantities of additives.

In the method of the invention a suspension is prepared from graphene oxide or reduced graphene oxide or pure graphene or chemically modified graphene and a liquid substance. The suspension is mixed to ensure uniform quality, and a desired other powdery raw material can be added into it. The suspension containing graphene oxide or reduced graphene oxide or pure graphene or chemically modified graphene and at least one other powdery material are mixed with each other, thus ensuring as good distribution as possible of the graphene oxide or reduced graphene oxide or pure graphene or chemically modified graphene to the powder material and especially to its surfaces. A graphene-based additive is used essentially because its dimension is considerably smaller than that of at least one other powdery material used so that it is able to distribute evenly i.e. homogeneously between the powder particles. In addition, the surface chemistry of graphene-based additives can be modified to be more compatible with a larger set of raw materials.

It is essential to choose the additive promoting laser ablation and the liquid substance i.e. solution suitable for the manufacture of the suspension so that the additive is dispersed into the liquid as well as possible, the blending of the suspension into the powdery raw-material is as efficient as possible, and further that the liquid solution can be easily removed from the compound during drying or compacting, when necessary. Good dispersion thus means uniform blending and distribution of a solid substance into the liquid.

When powdery source material particles are small, mixing them dry becomes more difficult along with the surface forces of the particles, because the internal frictional force and caking of the particles are strengthened. This leads to that the powder and additives are not homogeneously mixed with each other and that the powdery source material can also become dirty because of the wear particles detaching from the blending equipment. The blending becomes easier when mixed into a liquid phase, because the particles can be coerced separate chemically and friction in the liquid is relatively small so that the powder mixture can be blended into a sufficiently homogeneous mixture. Another significant benefit in the use of liquid dispersion is that the particles can be packed more tightly in the formation phase of the object manufacture before sintering, which guarantees a more high-quality and repeatable end result in the manufacture of the target piece.

When the powder in the solution (including both matrix and blend particles) has a very small distribution, with a diameter of approximately 0-1 µm, gravitation is no longer a determining interaction force, but the polar and non-polar forces generating onto the particle surfaces dictate how the particles behave in the solution. Surface forces can be artificially modified by modifying the surface chemistry of the particles.

Carbon in its basic form is a non-polar material, when again water is a strongly polar substance. This means that carbon does not mix with water but it tends to reach the outer surfaces of an aqueous phase and carbon also tends to clod in water. Carbon can be changed to be compatible with water by adding surface molecules, which are polar. Such a compatible form of carbon is graphene oxide, which consists of a sheet with a thickness of one carbon atom, with polar groups attached to the surface, the groups forming a measurable (polar) surface charge to the surface of the carbon sheet. The use of organic solvents as liquid phase is then avoided. Organic solvent substances are non-polar so that it is possible to mix pure carbon with these. However, they are expensive compared to water, difficult to recycle, their availability is limited and several of them are poisonous.

However, if a powdery matrix substance s non-polar, such as fluorinated polymer, also non-polar forms of graphene and/or organic solvents, such as ethanol, acetone, isopropanol, etc. can be used in the invention. Non-polar forms of graphene comprise chemically or thermally reduced graphene oxide and pure graphene. However, the availability of pure graphene is poor compared to graphene oxide, which is relatively easy and cost-effective to manufacture.

After mixing, the solvent containing graphene oxide and the powdery material are compacted into a solid target material by means of pressure and temperature, making use, among others, of the following methods:
- uniaxial compression and sintering
- cold-isostatic compression and sintering
- cold-isostatic compression, sintering and hot-isostatic compression
- sediment casting or pressure casting, drying and sintering
- extrusion and sintering
- Spark Plasma Sintering (SPS)

Also other existing methods or combinations of these can be used for compacting a powdery raw material and a material intensifying laser ablation mixed with it into a target material. The methods are selected according to the powdery raw materials used and the shape of the object.

Target material is used as original raw material in a laser ablation process after compacting, finishing cutting and grinding. Laser pulses are targeted to the target material, which release material from the target with different mechanisms and combinations of these. Material is detached from the target e.g. by vaporization, so-called cold ablation and as particles. It is essential to generate such a combination of material unfastening mechanisms that both the desired coating structure and adhesion to the substrate material and improvement of productivity to a desired level can be produced.

Additive additions to a powdery original raw material can have an impact on the intensification of the laser ablation process with several different mechanisms. Additive additions can improve the energy absorption of the target material so that a smaller energy import to the target material is needed to detach the same amount of material from the target compared to a target material with a smaller absorption ability. The additive addition can also affect the energy penetration depth to the target material so that energy is absorbed into the thin surface layer without penetrating deeper into the target material. This may have advantageous effects, especially when it is desired to avoid particles detaching from the target material. Additives can also have a lower ablation threshold than the powdery raw material, i.e. the material is dispersed into atoms or ionized on lower energy levels than on which a pure powdery raw material would ablate. Naturally additives only impact on the area, to which they travel during blending and compacting. In an extreme case, if no diffusion occurs, additives are essentially on the boundary layers of the particles, where they affect the detachment mechanisms of materials. Additives can also mechanically weaken the connections between powdery particles and thus promote especially the transfer of material from the target material into a coating, based on the detachment of particles. In addition, additives can have an impact on other properties of the target material, such as thermal conductivity, granular size as well as electric and magnetic properties, which in their part can change the laser-material interaction and ablation process compared to a target material without additives.

In the use of blending and the selection of the size distribution of powdery particles it has to be taken into account, with which mechanisms the blending intensifying laser ablation works. If the effect intensifying laser ablation is based, for example, on the impact weakening the bonds between particles and the blend is located in the target material on the boundary surface of the particles, it is in this way possible to affect the quantity and size of particles and thus the micro- and nanostruc-ture of the coating. In addition to blending also laser parameters have to be adjusted so that the material detaching from the target consists in a suitable proportion of particles and atomized and ionized material in order to achieve a suitable microstructure, porosity, adhesion and strength between the particles in the coating.

### Brief description of the drawings

Figure 1 illustrates powder particles and an additive in a solid form in the method for manufacturing a target material piece of the invention;
Figure 2 illustrates a suspension formed by an additive and liquid solvent substance in a vessel as an intermediate step of the manufacturing method;
Figure 3 illustrates a mixture of the powder particles and suspension as an intermediate step of the manufacturing method;
Figure 4 illustrates a compressed initial blank as an intermediate result of the manufacturing method;
Figure 5 illustrates the initial blank after sintering, which is a target material piece only lacking the abrasion step; and
Figure 6 illustrates the basic principle of a coating method using laser ablation, in which a target material piece manufactured with the manufacturing method of the invention is used as the target.

### Detailed description of the invention

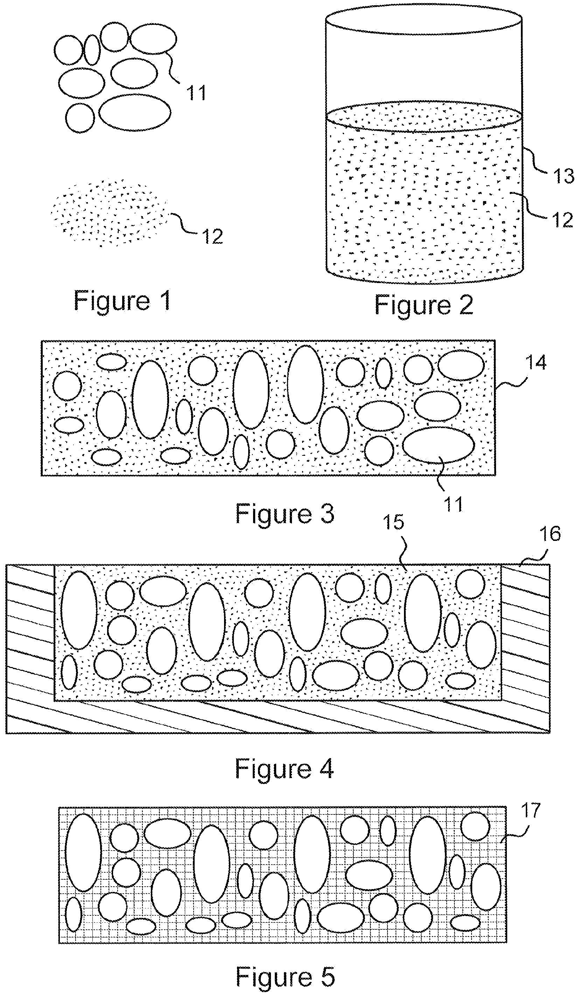

In the description of the method it is referred to the manufacturing process of target material pieces in accordance with Figures 1-5.

In the method of the invention, in its one embodiment option, the method comprises the following steps:
- A suspension is prepared of powdery original substances (i.e. raw materials), which consists either wholly or partially of oxide ceramics or fluorinated polymer, and additives, such as graphene oxide or reduced graphene oxide or pure graphene or chemically modified graphene and in addition to these, of a solvent, which is selected according to the powdery original substances used;
- Possible process additives are added to the suspension according to the powdery original substances and the solvent used as well as the form-giving method chosen for the target (i.e. the target material piece). The process additives make it possible e.g. to compact the target at a later stage or they are other compound substances used in the processing and manufacture of the target.
- A homogeneous dispersion formed essentially of different substances is achieved to the suspension by mixing the suspension using a ball mill, ultrasound cavitation or in a respective manner.
- A homogeneous suspension is sediment or pressure cast as such or dried into powder for other form-giving methods, such as cold or hot isostatic compression.
- The solvent and possible process additives are removed after form-giving by heating the piece in a controlled manner.
- Sintering the piece in a high temperature, below the lowest melting point of the raw materials and in vacuum atmosphere or controlled atmosphere so that the target material piece obtains its final physical properties, such as porosity, granular size and mechanical properties.

When talking about suspensions, the combination of additives and a liquid is the so-called first suspension, and when still solid raw materials of the target are added to this first suspension as powders, the so-called second suspension is produced, which will then be processed further.

The mixing of substances in steps a) and b) (and the mixing of solid powdery substances between both solid substances and liquid into suspensions) can be made in an optional order.

Referring to Figures 1-5, in these figures there is shown an example of the different steps of the manufacturing method used, intermediate products and actions for the manufacture of a target material piece of the invention.

In the upper section of Figure 1, there is illustrated at least one powdery raw material 11 desired to be included in the target material piece, and in the lower section of the Figure there is illustrated the chosen additive 12. The granular size of the powdery raw material and the additive depicted as powdery and their interrelations can deviate from the ones that could be deduced from this simplified figure. There can be more than one powdery raw material; likewise, there can be several different additives, which can be blended to form one additive mixture 12. In one example of the invention, the additive 12 is a graphene derivative, i.e. a substance containing carbon, like one of the following: graphene oxide or reduced graphene oxide or pure graphene or chemically modified graphene. It is also possible to choose and blend two or several of these graphene derivatives in a desired way in order to form the desired additive mixture.

In Figure 2 there is illustrated in a simplified manner a vessel, into which the solvent to be used, i.e. liquid substance 13 has been poured first. The solvent 13 can be water or an organic liquid substance, for example, ethanol, acetone or isopropanol. An additive or additives 12 are blended into the liquid substance, and after mixing a uniform first suspension is obtained.

After this in Figure 3 there is show the next step, in which the second suspension 14 is formed. The powdery raw materials 11 are mixed into the first suspension, and the combination is mixed to be smooth using a desired method. In the second suspension 14, the substances are likewise evenly blended with each other, and the second suspension 14 consists of the liquid 13, powdery raw materials 11 for the target, and desired additives 12.

In Figure 4 there is illustrated the manufacture of the initial blank 15. In this, the second suspension 14 manufactured as mentioned above is poured into a mould 16, in which the preliminary processing into the initial blank 15 can be made by means of compression and/or pressure and/or temperature. In one embodiment the initial blank 15 is finished when the solvent substance 13 and additives 12 have been removed from the second suspension 14 by means of controlled heating.

Finally, in Figure 5 there is illustrated the sintering process for the finished initial blank 15, i.e. in sintering the initial blank 15 is heated to a high temperature; nevertheless, remaining in temperatures below the melting point of the raw material used (or in case of several raw materials, below the lowest melting point). In one example, the said compacting step is performed by using elevated pressure and/or elevated temperature so that the maximum temperature to be used in sintering is kept in the range of 50-90% from the melting point of the raw material 11 melting in the lowest temperature. In sintering, metal powder particles attaching tightly to each other are formed by means of so called cold bonding and also diffusion, a fixed and hard target material piece 17 being the result from this compacting step. In principle, the said sintered piece is a target material piece 17 ready for laser ablation, but in practice it is still useful to abrade the contact surface (the surface met by laser pulses) of the target material piece 17 smooth either mechanically or chemically. In other words, the outer surface of the piece can be abraded or machined smooth so that the desired tolerance is achieved for the smoothness of the surface. In one example the maximum difference in height between the deepest point and the highest point of the processed surface is 500 micrometres, i.e. the tolerance is max. ± 250 µm. In this case, when using the target material piece in the laser ablation process it is possible to better control the material detaching from the piece and the particle size of the material when the surface is sufficiently smooth upon starting the ablation process.

After the abrasion, the manufacturing method provides a target material piece 17 equipped with the desired properties.

The compaction step from the second suspension 14 into the finished target material piece 17 can also alternatively be carried out by above-mentioned alternative methods, in which sintering is in practice always included as one step, because the raw materials can generally be, for example, metal or metal oxide or organic substance, such as aluminium oxide or Teflon (PTFE). In one example of the invention, the said combination of powdery raw materials contains at least 50% aluminium oxide.

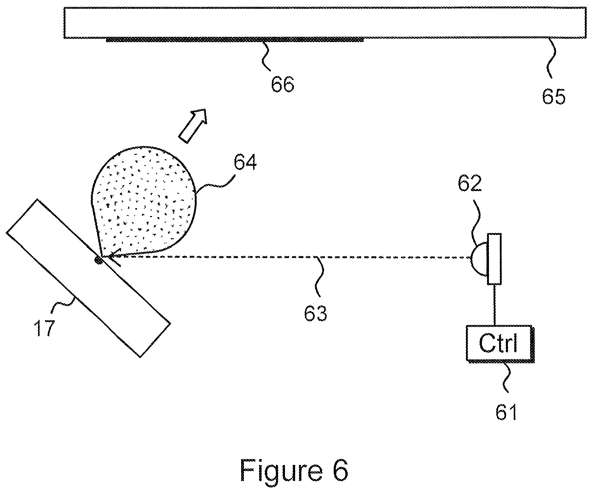

Reference is next made to Figure 6, in which there is illustrated the basic principle of laser ablation and a coating arrangement applying it, in which the target material piece manufactured with the method of the invention is used. An important source of the arrangement is a laser pulse source 62, of which there can be one or several. The laser pulse source 62 is controlled by a controller 61, which can be a controller unit integrated into the laser source or an outer control or even a control obtained through cloud service for the use of laser. Controllable parameters relating to the laser source are the duration of an individual laser pulse, the energy or intensity of the pulse. Likewise, optical control, for example, in the form of a lens or mirrors or mechanical filtering can be linked with the "beam" formed by the laser pulses. When needed, the pulse string 63 can also be divided into several separate pulse strings either mechanically or optically.

The pulse string is guided and focused at the desired point of the target material piece 17 (its abraded surface), which has been prepared in advance using the method of the invention. When the laser pulses 63 meet the surface of the target material piece 17, there occurs so called cold ablation, in which particles and plasma detach as a substance flow with a small distribution from the surface of the target material piece 17. Naturally, the ablation point on the surface of the target material piece 17 has to be positioned to move on the surface of the target so that material wears evenly and there is no danger of big "blocks" of particles detaching, if the surface is too uneven. Movement of the ablation point on the target can be realized by moving the laser beam, for example, through the rotational movement of the laser source or an optical element or by moving/rotating the target material piece itself. The location point of the target or the angle of its surface i.e. position in relation to the direction of the arriving laser beam largely defines the direction, to which the detached material flow 64 will go. When needed, the detached material flow can be prevented from, for example, returning straight back to the direction of the laser source 62 by physical protective structures and also for narrowing the "cone" of the material flow to be of a desired width.

When the material flow arrives at the surface of the base i.e. substrate 65 it hits and attaches tightly to the lower surface of the substrate 65 (in the geometry of Figure 6), thus forming the coating 66. It depends on the structure and composition of the target material piece 17 and the laser parameters, which kind of a coating 66 is finally generated. When needed, it is also possible to produce a porous coating 66, which has a desired percentage of empty parts from the entire volume of the coating. The material of the coating 66 has naturally been determined in the manufacturing process of the original target material piece already through the selection of the powdery raw materials 11.

In other words, the inventive idea of the present invention also comprises the use of the manufactured target material piece using laser ablation apparatus for different embodiments in the manufacturing process of coatings. In this case laser pulses transmitted by at least one laser source are targeted at the target material piece in the said laser ablation process for detaching the target material from the target material piece, and the said detached target material is directed to the base, onto which a coating is this way formed. A respective laser ablation process typically comprises
- at least one laser source 62 for transmitting laser pulses 63
- a target material piece 17, to the surface of which laser pulses 63 are directed with desired optical and mechanical arrangements and
- substrate material 65, to the direction of which the material flow 64 detaching from the target material piece 17 is directed and onto the surface of which a coating 66 provided with desired properties is formed from the material flow 64 detached from the target material piece.

The apparatus, which is not claimed, is characterised in that the target material piece is manufactured using the method mentioned in this specification before commencing the laser ablation arrangement and process, taking into account different embodiment options. Naturally, different parts of the apparatus have to be simultaneously aligned and placed into the correct places, and the manufactured target material piece has to be placed exactly to the desired place and angle of alignment in relation to the laser beam (or beams) targeted at it in relation to the location of the base. When needed, the apparatus can be placed inside a so called ablation chamber so that a desired atmosphere can be arranged in the ablation chamber by means of gases or a vacuum. In the latter case, one can thus talk about a coating process occurring in a vacuum chamber.

In the invention, powdery raw material refers widely taken to original material with a variable granular size. Powder can thus be of a very fine distribution, the granular size i.e. the diameter of an individual grain being in the size range of even under 1 micrometre (taken into account both the target's raw material and additive); or it can be coarser, like the granular sizes with the diameter in the example. In one example, the granular size of powdery raw materials is under 3000 nm, i.e. 3 micrometres for all raw materials used. The powder can have an essentially uniform grain distribution, or the granular size can vary within a certain range. The granular size of additives can in one example be under 1,5 micrometres, i.e. 1500 nm for all used additives.

The task of an additive is to intensify the laser ablation process e.g. by improving absorption or lowering the ablation threshold, as has been described above.

In an embodiment of the invention a target manufactured with the manufacturing method of the invention can be used for coatings, which are needed in energy storing or production applications. Examples of such embodiments are different coatings in lithium ion batteries. More closely, such coatings can be coatings needed in the separator films of lithium ion batteries.

In one embodiment of the invention the substrate, onto which the coating is prepared, is a polymer.

Of the coatings obtained as a result in the said laser ablation process some exemplary thicknesses can be 10-5000 nm, or still more closely defined, the thickness of the coating to be manufactured can be 200-1500 nm.

In the laser ablation process it is possible to adjust numerous parameters, such parameters being, among others, the repetition frequency of laser pulses transmitted by the laser source, pulse length i.e. timely duration of one pulse, pulse interval i.e. timely pause between two pulses, pulse energy or intensity, and possible distribution of pulses or other optical or mechanical guiding in the travel paths of pulses between the laser source and hitting the target material piece.

In one example laser pulses transmitted by a laser source are targeted at the target material piece on a repetition frequency, which is bigger than 100 kHz.

In a second example laser pulses transmitted by a laser source are targeted at the target material piece on a repetition frequency, which is between 500 kHz-40 MHz.

In one example the laser source is controlled so that the length of an individual laser pulse transmitted from it is under 100 ps. A serial pulse string is formed of the pulses, which can be switched on and off at desired points of time.

In another example the laser source is controlled so that the length of an individual laser pulse transmitted from it is between 1-10 ps.

In an example the laser source is controlled so that the pulse energy of an individual laser pulse transmitted from it is between 2-100 µJ. In another example the pulse energy can be chosen to be between 30-100 µJ.

When talking about raw materials used for the target, in one example of the invention the granular size of the powdery material i.e. the diameter of the grain is chosen to be smaller than 5000 nm.

In another example the granular size in question i.e. the diameter of the grain is chosen to be between 20-2000 nm.

In an example of the invention the additive is graphene oxide or reduced graphene oxide or pure graphene or chemically modified graphene. One additional option is to compose the additives as a desired combination, for example, of substances comprising carbon with desired percentages, thus containing the above-mentioned 1-4 graphene-based substance(s).

In an example of the invention the powdery raw material used can be inorganic material or organic material. In another example of the invention the powdery raw material can be a desired oxide.

In an embodiment of the invention, when talking about said powdery raw materials, one raw material is chosen to be polytetrafluoroethylene i.e. Teflon (so-called PTFE).

As the end result of the method of the invention it has been observed that the ablation threshold needed in laser ablation, defined by energy density J/cm² is at least 20 % lower with the target material piece manufactured in the invention than with unblended target materials of a known technology.

As additional parameters in the laser ablation process and using the target material piece of the invention it has been noted that the amount of material detaching from the target material piece is at least 5 mg/J in relation to the total laser energy targeted at the target material piece.

In an embodiment of the invention, it is possible to manufacture coatings, the porosity of which is at least 20 per cent by volume of the entire volume of the coating, when using target material pieces of the invention in the laser ablation process. This is made possible by the use of suitable laser parameters (pulse energy, scanning) and process circumstances (pressure, temperature, distance between the target and base) and by optimising the structure and composition of the target material piece.

In the invention, the compacting of the target material piece can be carried out in a separate chamber. This can be a chamber, into which a vacuum has been generated, or a desired type of atmosphere can be generated into the chamber before the action by means of controlled atmosphere. The controlled atmosphere can be a desired inert gas, which does not react with other substances when the temperature rises higher during the compaction. An example of such a gas in the presented process is argon.

The method of the present invention has the following benefits:
- The detachment speed of the material from the target in laser ablation can be increased, thus promoting the transfer of the material as a coating on the surface of the substrate and reducing production costs.
- The same productivity can be achieved with a lower power of the laser source (or laser sources) and use of laser energy compared to an unblended target material so that it is possible to use cheaper laser apparatus with lower power.
- Warming up of the target material can be reduced, due to the smaller need to bring energy to the surface of the target material.
- The detachment kinetics of particles from the target can be adjusted in a desired manner and thus modify the nano- and microstructure of the coating to be produced; in other words, it is possible to adjust the structure of the coating to be produced in a controlled manner; and
- The thermal load of the substrate material can be reduced, if the same transfer efficiency of the target material can be achieved by a smaller use of laser energy.

In the invention, the graphene-based raw material can in principle be formed also of other allotropic forms of carbon, such as carbon particles, graphite, nanotubes and/or fullerenes. In an embodiment of the invention several different allotropes of carbon can be included with different desired shares of the entire graphene-based raw material.

As the final result, the present invention makes possible a more effective production process for the manufacture of different coatings, the use of possibly cheaper production apparatuses and the possibility to tailor coatings in a new way.

In the invention it is possible to combine the above described individual features of the invention mentioned in the independent claims into new combinations, in which two or more individual features can have been included in the same embodiment.

The present invention is not restricted only to the examples disclosed above, but many variations are possible within the scope defined by the enclosed claims.

## Claims

1. Method for manufacturing a target material piece (17) and subsequently using the target material piece (17) in a laser ablation process, **characterized in that** the method comprises the following steps:
- at least one powdery raw material (11) desired for the target material piece is manufactured or taken into use;
- at least one additive (12) is mixed into a liquid substance (13), forming a first suspension (12, 13) of uniform quality, in which the said additive (12) is graphene oxide or reduced graphene oxide or pure graphene or chemically modified graphene, and in which the liquid substance (13) is water, ethanol, acetone or isopropanol, wherein the additive (12) is configured to change the laser-material interaction and ablation process of the target material piece (17) compared to a target material without additives;
- the said first suspension (12, 13) and at least one said powdery raw material (11) are mixed, forming a second suspension (14) of uniform quality;
- the said second suspension (14) is compacted into a solid target material piece (17) by means of pressure and/or temperature;
- in the said laser ablation process laser pulses (63) transmitted by at least one laser source (62) are targeted at the target material piece (17) for detaching target material (64) from the target material piece (17), and the detached target material is directed to a substrate (65), onto which a coating (66) is in this way formed.

2. Method according to claim 1, **characterized in that** of the said additives (12) at least two different substances are comprised in the first mixing step from a group of: graphene oxide, reduced graphene oxide, pure graphene and chemically modified graphene.

3. Method according to any of the preceding claims 1-2, **characterized in that** the individual powdery raw material (11) is oxide or organic material or inorganic material.

4. Method according to claim 3, **characterized in that** the said combination of powdery raw materials consists of at least 50% of aluminium oxide.

5. Method according to any of the preceding claims 1-4, **characterized in that** polytetrafluoroethylene is chosen as one powdery raw material (11).

6. Method according to any of the preceding claims 1-5, **characterized in that** the granular size of the powdery raw materials (11) is chosen to be less than 3000 nm and the granular size of the additives (12) is chosen to be less than 1500 nm.

7. Method according to any of the preceding claims 1-6, **characterized in that** the mixing of substances in the manufacture of the first (12, 13) and/or second suspension (14) is carried out by a ball mill or ultrasound cavitation.

8. Method according to any of the preceding claims 1-7, **characterized in that** the method further comprises the following step:
- at least one process additive is added to the second suspension (14).

9. Method according to any of the preceding claims 1-8, **characterized in that** in the said compacting step the second suspension (14) is first formed into an initial blank (15) and after this it is subjected to sintering.

10. Method according to claim 9, **characterized in that** in the said compacting step the initial blank (15) is first heated in a controlled manner to remove liquids and possible process additives, and after this the processed initial blank consisting of a solid material is sintered by heating it further in a controlled manner to a higher temperature to form the target material piece (17).

11. Method according to any of the preceding claims 1-10, **characterized in that** the said compacting step is carried out by using at least one of the following methods: uniaxial compression, cold isostatic compression, hot isostatic compression, sediment casting, extrusion, pressure casting and/or sintering.

12. Method according to any of the preceding claims 1-11, **characterized in that** the said compacting step is carried out by using elevated pressure and/or elevated temperature so that the maximum temperature used in sintering is kept in the range of at most 50 - 90% from the melting point of the powdery raw material (11) melting at the lowest temperature.

## Patentansprüche

1. Verfahren zur Herstellung eines Zielmaterialstücks (17) und anschließende Verwendung des Zielmaterialstücks (17) in einem Laserabtragungsprozess, **dadurch gekennzeichnet, dass** das Verfahren die folgenden Schritte umfasst:
- mindestens ein pulverförmiges Rohmaterial (11), das für das Zielmaterialstück gewünscht wird, hergestellt oder in Verwendung genommen wird;
- mindestens ein Zusatzstoff (12) in eine flüssige Substanz (13) gemischt wird, wodurch eine erste Suspension (12, 13) von gleichmäßiger Qualität gebildet wird, wobei der Zusatzstoff (12) Graphenoxid oder reduziertes Graphenoxid oder reines Graphen oder chemisch modifiziertes Graphen ist, und wobei die flüssige Substanz (13) Wasser, Ethanol, Aceton oder Isopropanol ist, wobei der Zusatzstoff (12) konfiguriert ist, um die Laser-Material-Interaktion und den Abtragungsprozess des Zielmaterialstücks (17) im Vergleich zu einem Zielmaterial ohne Zusatzstoffe zu verändern;
- die erste Suspension (12, 13) und mindestens ein pulverförmiges Rohmaterial (11) vermischt werden, wodurch eine zweite Suspension (14) von einheitlicher Qualität gebildet wird;
- die zweite Suspension (14) durch Druck und/oder Temperatur zu einem festen Zielmaterialstück (17) verdichtet wird;
- in dem Laserabtragungsprozess Laserimpulse (63), die von mindestens einer Laserquelle (62) ausgesendet werden, auf das Zielmaterialstück (17) gerichtet werden, um Zielmaterial (64) von dem Zielmaterialstück (17) abzulösen, und das abgelöste Zielmaterial auf ein Substrat (65) gerichtet wird, auf dem auf diese Weise eine Beschichtung (66) gebildet wird.

2. Verfahren nach Anspruch 1, **dadurch gekennzeichnet, dass** von den Zusatzstoffen (12) mindestens zwei verschiedene Substanzen im ersten Mischschritt umfasst werden aus einer Gruppe von: Graphenoxid, reduziertem Graphenoxid, reinem Graphen und chemisch modifiziertem Graphen.

3. Verfahren nach einem der vorstehenden Ansprüche 1 bis 2, **dadurch gekennzeichnet, dass** das individuelle pulverförmige Rohmaterial (11) Oxid oder organisches Material oder anorganisches Material ist.

4. Verfahren nach Anspruch 3, **dadurch gekennzeichnet, dass** die Kombination von pulverförmigen Rohmaterialien zu mindestens 50 % aus Aluminiumoxid besteht.

5. Verfahren nach einem der vorstehenden Ansprüche 1 bis 4, **dadurch gekennzeichnet, dass** Polytetrafluorethylen als ein pulverförmiges Rohmaterial (11) gewählt wird.

6. Verfahren nach einem der vorstehenden Ansprüche 1 bis 5, **dadurch gekennzeichnet, dass** die Korngröße der pulverförmigen Rohmaterialien (11) auf weniger als 3000 nm und die Korngröße der Zusatzstoffe (12) auf weniger als 1500 nm eingestellt ist.

7. Verfahren nach einem der vorstehenden Ansprüche 1 bis 6, **dadurch gekennzeichnet, dass** das Mischen von Substanzen bei der Herstellung der ersten (12, 13) und/oder zweiten Suspension (14) durch eine Kugelmühle oder Ultraschallkavitation erfolgt.

8. Verfahren nach einem der vorstehenden Ansprüche 1 bis 7, **dadurch gekennzeichnet, dass** das Verfahren ferner den folgenden Schritt umfasst:
- mindestens ein Prozesszusatzstoff zu der zweiten Suspension (14) hinzugefügt wird.

9. Verfahren nach einem der vorstehenden Ansprüche 1 bis 8, **dadurch gekennzeichnet, dass** im Verdichtungsschritt die zweite Suspension (14) zunächst zu einem ersten Ausgangsrohling (15) geformt und danach einer Sinterung unterzogen wird.

10. Verfahren nach Anspruch 9, **dadurch gekennzeichnet, dass** in dem Verdichtungsschritt der Ausgangsrohling (15) zunächst kontrolliert erwärmt wird, um Flüssigkeiten und eventuelle Prozesszusatzstoffe zu entfernen, und danach der verarbeitete Ausgangsrohling, der aus einem festen Material besteht, durch weiteres kontrolliertes Erwärmen auf eine höhere Temperatur gesintert wird, um das Zielmaterialstück (17) zu bilden.

11. Verfahren nach einem der vorstehenden Ansprüche 1 bis 10, **dadurch gekennzeichnet, dass** der Verdichtungsschritt mit mindestens einem der folgenden Verfahren durchgeführt wird: einachsige Verdichtung, isostatische Kaltverdichtung, isostatische Warmverdichtung, Sedimentgießen, Strangpressen, Druckgießen und/oder Sintern.

12. Verfahren nach einem der vorstehenden Ansprüche 1 bis 11, **dadurch gekennzeichnet, dass** der Verdichtungsschritt unter Verwendung von erhöhtem Druck und/oder erhöhter Temperatur durchgeführt wird, sodass die maximale Temperatur, die beim Sintern verwendet wird, im Bereich von höchstens 50 bis 90 % des Schmelzpunkts des pulverförmigen Rohmaterials (11) gehalten wird, das bei der niedrigsten Temperatur schmilzt.

## Revendications

1. Procédé de fabrication d'une pièce de matériau cible (17) et utilisation ultérieure de la pièce de matériau cible (17) dans un processus d'ablation laser, **caractérisé en ce que** le procédé comprend les étapes suivantes :
- au moins une matière première en poudre (11) souhaitée pour la pièce de matériau cible est fabriquée ou mise en service ;
- au moins un additif (12) est mélangé à une substance liquide (13), formant une première suspension (12, 13) de qualité uniforme, dans lequel ledit additif (12) est de l'oxyde de graphène ou de l'oxyde de graphène réduit ou du graphène pur ou du graphène chimiquement modifié, et dans lequel la substance liquide (13) est de l'eau, de l'éthanol, de l'acétone ou de l'isopropanol, dans lequel l'additif (12) est configuré pour modifier l'interaction laser-matériau et le processus d'ablation de la pièce de matériau cible (17) par rapport à un matériau cible sans additifs ;
- ladite première suspension (12, 13) et ladite au moins une matière première en poudre (11) sont mélangées, formant une seconde suspension (14) de qualité uniforme ;
- ladite seconde suspension (14) est compactée en une pièce de matériau cible solide (17) au moyen de la pression et/ou de la température ;
- dans ledit processus d'ablation laser, des impulsions laser (63) transmises par au moins une source laser (62) sont dirigées vers la pièce de matériau cible (17) pour détacher le matériau cible (64) de la pièce de matériau cible (17), et le matériau cible détaché est dirigé vers un substrat (65), sur lequel un revêtement (66) est ainsi formé.

2. Procédé selon la revendication 1, **caractérisé en ce que**, parmi lesdits additifs (12), au moins deux substances différentes sont comprises dans la première étape de mélange d'un groupe constitué de : l'oxyde de graphène, l'oxyde de graphène réduit, le graphène pur et le graphène chimiquement modifié.

3. Procédé selon l'une quelconque des revendications précédentes 1 et 2, **caractérisé en ce que** la matière première en poudre individuelle (11) est un oxyde ou une matière organique ou une matière inorganique.

4. Procédé selon la revendication 3, **caractérisé en ce que** ladite combinaison de matières premières en poudre est constituée d'au moins 50 % d'oxyde d'aluminium.

5. Procédé selon l'une quelconque des revendications précédentes 1 à 4, **caractérisé en ce que** le polytétrafluoroéthylène est choisi comme l'une des matières premières en poudre (11).

6. Procédé selon l'une quelconque des revendications précédentes 1 à 5, **caractérisé en ce que** la taille granulaire des matières premières en poudre (11) est choisie pour être inférieure à 3000 nm et la taille granulaire des additifs (12) est choisie pour être inférieure à 1500 nm.

7. Procédé selon l'une quelconque des revendications précédentes 1 à 6, **caractérisé en ce que** le mélange des substances dans la fabrication de la première (12, 13) et/ou de la seconde suspension (14) est effectué par un broyeur à billes ou par cavitation ultrasonique.

8. Procédé selon l'une quelconque des revendications précédentes 1 à 7, **caractérisé en ce que** le procédé comprend en outre l'étape suivante :
- au moins un additif de procédé est ajouté à la seconde suspension (14).

9. Procédé selon l'une quelconque des revendications précédentes 1 à 8, **caractérisé en ce que**, dans ladite étape de compactage, la seconde suspension (14) est d'abord transformée en une ébauche initiale (15) et après cela elle est soumise à un frittage.

10. Procédé selon la revendication 9, **caractérisé en ce que**, dans ladite étape de compactage, l'ébauche initiale (15) est d'abord chauffée de manière contrôlée pour éliminer des liquides et des éventuels additifs de procédé, et après cela, l'ébauche initiale traitée, constituée d'un matériau solide, est frittée en la chauffant davantage de manière contrôlée à une température plus élevée pour former la pièce de matériau cible (17).

11. Procédé selon l'une quelconque des revendications précédentes 1 à 10, **caractérisé en ce que** ladite étape de compactage est réalisée en utilisant au moins l'un des procédés suivants : compression uniaxiale, compression isostatique à froid, compression isostatique à chaud, coulée par sédimentation, extrusion, coulée sous pression et/ou frittage.

12. Procédé selon l'une quelconque des revendications précédentes 1 à 11, **caractérisé en ce que** ladite étape de compactage est réalisée en utilisant une pression élevée et/ou une température élevée de sorte que la température maximale utilisée dans le frittage soit maintenue dans la plage d'au plus 50 à 90 % du point de fusion de la matière première en poudre (11) fondant à la température la plus basse.
